(19) Europäisches Patentamt

European Patent Office

Office européen des brevets

(11) Veröffentlichungsnummer: **0 667 536 A2**

## (12) EUROPÄISCHE PATENTANMELDUNG

(21) Anmeldenummer: **95101662.5**

(51) Int. Cl.⁶: **G01S 7/40**

(22) Anmeldetag: **08.02.95**

(30) Priorität: **15.02.94 DE 4404736**

(43) Veröffentlichungstag der Anmeldung:
**16.08.95 Patentblatt 95/33**

(84) Benannte Vertragsstaaten:
**DE ES FR GB NL**

(71) Anmelder: **Daimler-Benz Aerospace
Aktiengesellschaft**

**D-81663 München (DE)**

(72) Erfinder: **Brokmeier, Axel, Dipl.-Ing.**
**Auweg 6**
**D-89233 Neu-Ulm (DE)**

(74) Vertreter: **Fröhling, Werner Otto, Dr.**
**Daimler-Benz Aerospace AG**
**Patentabteilung**
**Wörthstrasse 10**
**D-89077 Ulm (DE)**

(54) **Verfahren zum Testen einer FM-CW-Radaranlage und Anordnung zur Durchführung des Verfahrens.**

(57) Die Erfindung betrifft ein Verfahren zum Testen einer FM-CW-Radaranlage und eine Anordnung zur Durchführung des Verfahrens. Für den Frequenzbereich der verwendeten Radarsignale wird ein Sägezahngenerator mit einer hochgenauen Linearisierungsschaltung verwendet, die mit Hilfe eines lokalen Oszillaotrs einen ZF-Bereich erzeugt und dort ein verzögertes ZF-Signal erzeugt. Dieses wird mit dem LO-Signal hochgemischt zur Erzeugung eines Testsignales.

EP 0 667 536 A2

Die Erfindung betrifft ein Verfahren zum Testen einer FM-CW-Radaranlage nach dem Oberbegriff des Patentanspruchs 1 und eine Anordnung zur Durchführung des Verfahrens nach dem Oberbegriff des Patentanspruchs 5.

Die Erfindung ist insbesondere anwendbar auf eine FM-CW-Radaranlage (Frequency Modulated Continuous Wave), die auch frequenzmodulierte Dauerstrich-Radaranlage genannt wird, welche ein sogenanntes Frontend enthält. Dieses enthält in Abhängigkeit von der gewünschten Antennencharakteristik einen dementsprechend geformten Reflektor mit zugehörigem Erreger. Alternativ dazu ist die Verwendung einer Vielzahl sogenannter T/R-Module (Sende-/Empfangs-Module) möglich, die unmittelbar an Sende-/Empfangsstrahler-elemente gekoppelt sind. Solche T/R-Module sind vorzugsweise in Halbleitertechnologie aufgebaut und erzeugen bei einer Ausgangsfrequenz von z. B. 4 GHz eine Ausgangssendeleistung von z. B. 1 W.

Zum Testen einer solchen FM-CW-Radaranlage kann diese in einem bekannten Gelände aufgestellt und entsprechend den empfangenen bekannten Echosignalen justiert werden. Ergänzend oder alternativ dazu ist es naheliegend, an jedem Sende-/Empfangsstrahlerelement einen Koppelpunkt zum Ein-koppeln eines elektrischen Testsignals, das von einem durchstimmbarem Frequenzgenerator erzeugt wird, anzuordnen und damit die FM-CW-Radaranlage zu testen, das heißt prüfen und/oder einstellen.

Der Erfindung liegt die Aufgabe zugrunde, ein besonders kostengünstig und zuverlässig durchführbares Verfahren zum Testen einer FM-CW-Radaranlage anzugeben. Der Erfindung liegt außerdem die Aufgabe zugrunde, eine Anordnung zur Durchführung des Verfahrens anzugeben.

Diese Aufgabe wird gelöst durch die in den kennzeichnenden Teilen der Patentansprüche 1 und 5 angegebenen Merkmale. Vorteilhafte Ausgestaltungen und/oder Weiterbildungen sind den Unteransprüchen entnehmbar.

Die Erfindung wird im folgenden anhand eines Ausführungsbeispiels unter Bezugnahme auf eine schematisch dargestellte Figur näher erläutert. Diese zeigt einen durchstimmbaren, hochlinear arbeitenden Frequenzgenerator, der an seinem Ausgang Tx mit Hilfe eines spannungsgesteuerten Oszillators VCO ein Ausgangssignal erzeugt, z. B. in einem Frequenzbereich von 33 GHz bis 35 GHz. Der spannungsgesteuerte Oszillator VCO wird über eine Addierstufe Ad angesteuert von einem Funktionsgenerator FG, der z. B. ein sägezahnförmiges Steuersignal, das z. B. eine Periodendauer von 40 $\mu$s besitzt, erzeugt. Am Ausgang Tx entsteht ein Ausgangssignal mit einer Frequenz, die von dem Steuersignal abhängt. Zur Erzeugung eines hochlinearen Steuersignales, z. B. mit einem Linearitätsfehler kleiner gleich $10^{-4}$, wird dem Steuersignal des Funktionsgenerators FG an der Addierstufe Ad ein Regelsignal hinzugefügt.

Zur Erzeugung des Regelsignales wird am Ausgang Tx ein Teil des Ausgangssignals über einen ersten Koppler K1 ausgekoppelt, z. B. ein Leistungsanteil von -10 dBm, und einem Eingang eines ersten Mischers M1 zugeleitet.

Dem anderen Eingang wird über einen zweiten Koppler K2, dessen Funktion noch erläutert wird, ein hochstabiles, Signal eines lokalen Oszillators LO, der z. B. ein 32 GHz-Ausgangssignal erzeugt, zugeführt. An dem Ausgang MP1 des ersten Mischers entsteht ein ZF-Signal (Zwischenfrequenzsignal) z. B. bei einer Mittenfrequenz von ungefähr 1 GHz bis 3 GHz. Das ZF-Signal wird aufgeteilt in einen unverzögerten Teil und einen um die Verzögerungszeit $\tau$ verzögerten Teil. Beide Teile werden in einem zweiten Mischer M2 gemischt. An dessen Ausgang entsteht ein Signal mit einer Differenzfrequenz von z. B. 160 kHz. Diese Differenzfrequenz entsteht dadurch, daß während der Verzögerungszeit $\tau$ die Ausgangsspannung des Funktionsgenerators FG annähernd linear steigt (Rampengenerator) und damit auch die Frequenz des Ausgangssignals des spannungsgesteuerten Oszillators VCO. Die Differenzfrequenz wird in einem Diskriminator verglichen mit einer Referenzfrequenz, z. B. 160 kHz, die in einem hochstabilen Referenzoszillator, z. B. Frequenzstabilität £(f) $\approx$ -110 dBc/Hz in 10 Hz Abstand, erzeugt wird. Das Ausgangssignal des Diskriminators wird über ein Regelfilter der Addierstufe Ad zugeleitet.

Von dieser Anordnung wird nun in vorteilhafter Weise ein BITE-Signal (Built-In-Test) erzeugt, das zum Testen der FM-CW-Radaranlage verwendet wird. Dazu wird über einen dritten Koppler K3 ein Teil, z. B. -10 dBm, des verzögerten ZF-Signals ausgekoppelt und einem Eingang eines dritten Mischers M3 zugeleitet. An dem anderen Eingang liegt das über den zweiten Koppler K2 ausgekoppelte hochstabile Signal des lokalen Oszillators LO. In dem dritten Mischer M3 wird das über den dritten Koppler K3 ausgekoppelte verzögerte ZF-Signal wieder hochgemischt in den ursprünglichen Frequenzbereich, z. B. 33 GHz bis 35 GHz. Dieses hochgemischte Signal, das an dem dritten Meßpunkt MP3 anliegt, wird über ein Bandpaßfilter, zur Unterdrückung störender Mischprodukte, dem Empfänger der FM-CW-Radaranlage zugeleitet, z. B. über einen nicht dargestellten vierten Koppler unmittelbar in die Zuleitung der Empfangsantenne. Dem Empfänger wird damit ein Echosignal von einem Ziel simuliert, welches in einer Entfernung l = c•$\tau$/2 liegt, wobei c die Ausbreitungsgeschwindigkeit der Radarwellen (Lichtgeschwindigkeit) in dem Medium, im allgemeinen Luft, bedeutet, welches das Frontend umgibt.

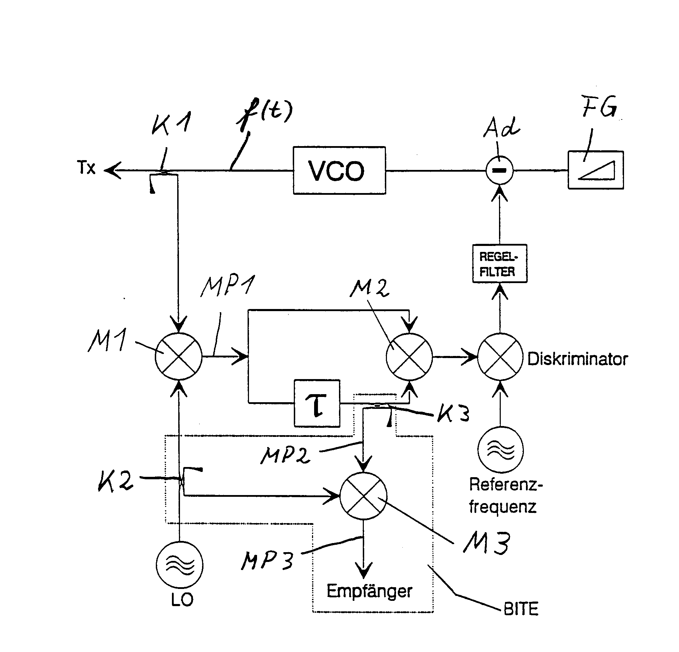

In der folgenden Tabelle werden die Spektren, die an den in der Figur dargestellten Meßpunkten MP1, MP2, MP3 entstehen, in Formeln dargestellt. Dabei ist $F(\omega)$ das Spektrum, das zu dem von der Zeit t abhängigen Ausgangssignal f(t) des spannungsabhängigen Oszillators VCO gehört. Zu dem Ausgangssignal des lokalen Oszillators LO gehört die Kreisfrequenz $\omega_o = 2\pi f_o$. $\tau$ bedeutet die bereits erwähnte Verzögerungszeit. Somit ergeben sich folgende Spektren: bedeutet die bereits erwähnte Verzögerungszeit. Somit ergeben sich folgende Spektren:

am Meßpunkt MP1:$F(\omega-\omega_o)+F(\omega+\omega_o)$
am Meßpunkt MP2:$F(\omega-\omega_o)\bullet e^{-j\omega\tau}+F(\omega+\omega_o)\bullet e^{-j\omega\tau}$
am Meßpunkt MP3:$F(\omega-\omega_o+\omega_o)\bullet e^{j(\omega+\omega_0)\tau}+F(\omega+\omega_o-\omega_o)\bullet e^{-j(\omega-\omega_0)\tau}+F(\omega-\omega_o-\omega_o)\bullet e^{j(\omega-\omega_0)\tau}+F(\omega+\omega_o+\omega_o)\bullet e^{-j(\omega+\omega_0)\tau}$

nach der Bandpaßfilterung ergibt sich:

$$F(\omega)\bullet e^{-j\omega\tau}\bullet(e^{-j\omega_0\tau}+e^{j\omega_0\tau})=F(\omega)\bullet e^{-j\omega\tau}\bullet 2\cos(\omega_o\tau).$$

Das ursprüngliche Ausgangssignal f(t) ist also nach dem Durchlauf durch die mit BITE bezeichnete und punktiert eingerahmte Schaltungsanordnung um die Verzögerungszeit $\tau$ verzögert und mit dem konstanten Faktor $2\bullet\cos(w_o\tau)$ multipliziert worden.

Die Erfindung ist nicht auf das beschriebene Ausführungsbeispiel beschränkt, sondern sinngemäß auf weitere anwendbar. Beispielsweise ist es möglich, die Verzögerungszeit $\tau$ stufenweise zu ändern, z. B. mit Hilfe entsprechender Verzögerungsglieder, so daß Ziele im gesamten Entfernungsbereich der Radaranlage simulierbar sind. Weiterhin kann durch eine Änderung der Verzögerungszeit $\tau$ um den Anteil $\Delta\tau$ ein in Entfernungsrichtung sich änderndes Ziel simuliert werden. Daraus läßt sich das Auflösungsvermögen in der Entfernungsrichtung bestimmen.

Weiterhin ist es möglich, die exemplarisch angegebenen Frequenzwerte an die erforderlichen Gegebenheiten der Radaranlage anzupassen.

**Patentansprüche**

1. Verfahren zum Testen einer FM-CW-Radaranlage mit Hilfe eines durchstimmbaren Frequenzgenerators, dessen Ausgangssignal in den Eingang der Radaranlage eingekoppelt wird,
   <u>dadurch gekennzeichnet,</u>
   - daß der Frequenzgenerator einen Regelkreis enthält zur Linearisierung des Frequenzverlaufes des Ausgangssignales,
   - daß in dem Regelkreis ein Teil des Ausgangssignales mit Hilfe eines lokalen Oszillatorsignales in eine Zwischenfrequenzlage umgesetzt wird und damit ein Regelsignal zur Ansteuerung eines spannungsabhängigen Oszillators (VCO) gewonnen wird,
   - daß zur Bildung des Regelsignales in der Zwischenfrequenzlage ein verzögertes sowie ein unverzögertes ZF-Signal verwendet wird und
   - daß das verzögerte ZF-Signal mit dem lokalen Oszillatorsignal in eine von dem Empfänger der Radaranlage auswertbare Frequenzlage gemischt wird, so daß ein Testsignal entsteht.

2. Verfahren nach Anspruch 1, dadurch gekennzeichnet, daß das verzögerte ZF-Signal um eine Verzögerungszeit $\tau$, die von der Entfernung l eines zu simulierendes Zieles abhängt, verzögert wird gemäß der Formel $l=c\bullet\tau/2$, wobei c die Ausbreitungsgeschwindigkeit der Radarwellen ist.

3. Verfahren nach Anspruch 1 oder Anspruch 2, dadurch gekennzeichnet, daß das Testsignal über ein Bandpaßfilter zur Unterdrückung störender Mischprodukte in den Eingang des Empfängers eingekoppelt wird.

4. Verfahren nach einem der vorhergehenden Ansprüche, dadurch gekennzeichnet, daß das Testsignal in eine Frequenzlage gemischt wird, die gleich derjenigen der zu empfangenden Echosignale ist.

5. Anordnung zur Durchführung des Verfahrens nach einem der vorhergehenden Ansprüche, dadurch gekennzeichnet, daß jeweils ein Koppler vorhanden ist zur Auskopplung des Ausgangssignales des lokalen Oszillators sowie des verzögerten ZF-Signales.

6. Anordnung nach Anspruch 5, dadurch gekennzeichnet, daß schaltbare Verzögerungsglieder vorhanden sind zur Einstellung unterschiedlicher Verzögerungszeiten $\tau$ derart, daß für ein simuliertes Ziel eine einstellbare Entfernung l wählbar ist gemäß der Formel $l=c\bullet\tau/2$, wobei c die Ausbreitungsgeschwindigkeit der Radarwellen ist.

7. Anordnung nach Anspruch 5 oder Anspruch 6, dadurch gekennzeichnet, daß das hochgemischte Testsignal zur Unterdrückung störender Mischprodukte ein Bandpaßfilter, das als Mikrostreifenleitungs-Filter ausgebildet ist, durchläuft.